**Europäisches Patentamt**

**European Patent Office**

**Office européen des brevets**

(19)

(11) Numéro de publication: **0 000 316**
**B1**

(12) **FASCICULE DE BREVET EUROPEEN**

(45) Date de publication du fascicule de brevet: **29.04.81**

(21) Numéro de dépôt: **78430001.4**

(22) Date de dépôt: **01.06.78**

(51) Int. Cl.³: **H 01 L 21/76,**
**H 01 L 21/265,**
**H 01 L 21/316**

(54) **Procédé de fabrication de dispositifs semi-conducteurs comportant des régions d'oxyde de silicium encastrées.**

(30) Priorité: **03.06.77 US 803182**

(43) Date de publication de la demande:
**10.01.79 Bulletin 79/1**

(45) Mention de la délivrance du brevet:
**29.04.81 Bulletin 81/17**

(84) Etats Contractants Désignés:
**DE FR GB**

(56) Documents cités:
US - A - 3 773 566
US - A - 3 966 501

IBM TECHNICAL DISCLOSURE BULLETIN,
vol. 17, n°. 3, août 1974
New York (USA)
V. L. RIDEOUT et al: "Fabricating recessed oxide isolation regions in silicon substrates" pages 949—951.

IBM TECHNICAL DISCLOSURE BULLETIN,
vol. 18, n°. 5, octobre 1975,
New York (USA)
V. L. RIDEOUT "Reducing lateral oxidation in recessed oxide isolated structure", page 1616.

IBM TECHNICAL DISCLOSURE BULLETIN,
vol. 19, n°. 11, avril 1977,
New York (USA)
H. S. BHATIA et al. "Isolation process for shallow junction devices" page 4171.

(73) Titulaire: **International Business Machines Corporation**
**Armonk, N.Y. 10504 (US)**

(72) Inventeur: **Crowder, Billy Lee**
**Oscawana Lake Road**
**Putnam Valley, New York 10579 (US)**
Inventeur: **Hunter, William Ralph**
**20 Marshall Place**
**Ossining, New York 10562 (US)**
Inventeur: **Ormond, Jr. Douglas William**
**52 Iroquois Road**
**Ossining, New York 10562 (US)**

(74) Mandataire: **Klein, Daniel**
**COMPAGNIE IBM FRANCE Département de Propriété Industrielle**
**F-06610 La Gaude (FR)**

Courier Press, Leamington Spa, England.

Procédé de fabrication de dispositifs semi-conducteurs comportant des régions d'oxyde de silicium encastrées

*Domaine de l'invention*

La présente invention concerne, la fabrication de dispositifs semi-conducteurs comportant des régions d'oxyde encastrées et plus particulièrement, un procédé d'application directe d'un masque de nitrure sur un substrat, typiquement de silicium, préalablement endommagé par une étape d'implantation ionique suivie par un recuit.

*Description de l'art antérieur et énoncé du problème*

Il est bien connu dans la fabrication des dispositifs semi-conducteurs comportant des régions d'oxyde encastrées qui sont délimitées par un masque composé par exemple par du nitrure de silicium, que simultanément à la croissance de la région d'oxyde épais, il se développe aussi une région d'oxyde mince en saillie au-dessous dudit masque. Cette saillie qui se trouve dans la zone où sera réalisée la région de porte dans le cas de la fabrication d'un dispositif MOS FET, est appelée "bec d'oiseau" en raison de son profil en forme de bec et sa présence est attribuée à une diffusion latérale d'oxygène sous la couche de dioxyde de silicium mince qui est disposée entre le masque de nitrure de silicium et la surface du substrat typiquement, de silicium. On utilise cette couche de dioxyde de silicium mince parce que le dépôt du masque de nitrure de silicium directement sur le substrat de silicium entraînerait des défauts provoqués par des contraintes et des dislocations dans le substrat de silicium qui affecteraient de façon défavorable les performances du dispositif. Malheureusement, l'utilisation de cette couche de dioxyde de silicium pour empêcher l'apparition de ces défauts entraîne la formation de ces becs d'oiseaux indésirables comme on l'a vu ci-dessus.

Ce problème étant posé, il y a eu de nombreuses tentatives pour améliorer les procédés de fabrication et minimiser la formation de ces becs d'oiseaux, souvent en continuant à utiliser cette couche intermédiaire de dioxyde de silicium.

Par exemple, le brevet US—A—3 961 999 décrit un procédé permettant de réduire les problèmes posés par l'apparition des becs d'oiseaux. Dans ce brevet, la couche de dioxyde de silicium est classiquement située entre le substrat de silicium et la couche de nitrure de silicium. Ce brevet précise que des trous sont d'abord réalisés par décapage dans le dioxyde de silicium; ces trous correspondent aux ouvertures pratiquées préalablement dans le masque de nitrure mais présentent un diamètre d'ouverture plus important. Le silicium du substrat est éliminé dans les trous. Une couche de silicium est donc déposée globalement sur toute la structure, puis cette dernière est oxydée. Les régions d'isolement diélectrique encastrées sont relativement planes, mais les problèmes posés par la présence des becs d'oiseaux ne sont pas totalement résolus.

Par exemple, le brevet US—A—3 900 350 décrit une solution qui permet de réduire les becs d'oiseaux en utilisant une couche de silicium polycristallin sous le masque d'oxydation à la place de l'oxyde de silicium habituel. En outre ce brevet met en évidence les défauts créés par les contraintes, qui apparaissent lorsque le masque d'oxydation de nitrure de silicium est disposé directement sur le substrat de silicium.

Ces deux brevets sont classiques. Ils préconisent l'utilisation d'une couche intermédiaire placée entre le masque de nitrure et le substrat de silicium, en essayant de réduire au minimum les problèmes posés par les becs d'oiseaux.

Cette technique est également utilisée dans la publication IBM Technical Disclosure Bulletin, Vol. 18, No. 5, octobre 1975, page 1616. Dans ce procédé on tient compte du fait, que les portions de silicium, préalablement endommagées par une implantation ionique, s'oxydent avec une vitesse plus grande que les parties non endommagées. Il est connu de cette publication pour réduire l'oxydation latérale un procédé de fabrication de dispositifs semi-conducteurs comportant des régions d'oxyde encastrées réalisées à partir d'un masque d'oxydation formé sur une surface d'un substrat semi-conducteur, qui comporte la séquence d'étapes suivantes:

(A) formation d'un masque d'oxydation selon une configuration désirée;

(B) implantation d'ions non dopants à travers ladite surface pour créer dans ledit substrat semi-conducteur, une couche superficielle endommagée jusqu'à une profondeur contrôlée;

(C) oxydation des régions du substrat exposées à travers les ouvertures dudit masque d'oxydation.

Des cette même publication les caractéristiques des parties caractérisantes des revendications 4, 5 et 8 du present brevet européen sont connues ainsi que les ions Ar, O et Si, mentionnés dans la revendications 7.

A l'évidence ce procédé ne peut que réduire la formation des becs d'oiseaux indésirables (comme l'indique le titre de l'article) et non pas les supprimer en raison de l'existence même de cette sous couche intermédiaire en dioxyde de silicium.

*Exposé de la présente invention*

Le procédé de la présente invention est intéressant par le fait qu'il élimine ce besoin de disposer d'une couche intermédiaire, entre le masque de nitrure et le substrat, et qui avait pour conséquence le développement de ces becs d'oiseaux. En outre le procédé de la présente invention permet au masque de nitrure d'être déposé directement sur le substrat de silicium tout en éliminant les défauts par contraintes qui apparaissaient habituellement avec cette pratique.

La présente invention a pour objet un procédé de fabrication de dispositifs semi-conducteurs comportant des régions d'oxyde encastrées réalisées à partir d'un masque d'oxydation formé sur une surface d'un substrat semi-conducteur, qui comporte la séquence d'étapes suivantes:

(A) implantation d'ions non dopants à travers ladite surface pour créer dans ledit substrat semi-conducteur une couche superficielle endommagée jusqu'à une profondeur contrôlée et recuit pour créer un réseau dense de dislocations,

(B) formation du masque d'oxydation directement sur ladite surface du substrat semi-conducteur selon une configuration désirée,

(C) oxydation des régions du substrat exposées à travers les ouvertures dudit masque d'oxydation et

(D) élimination dudit masque d'oxydation après l'oxydation.

L'étape d'endommagement initial de la surface du substrat de silicium par une implantation ionique jusqu'à une profondeur contrôlée, est suivie ensuite par une étape de recuit pour créer un réseau dense de dislocations. Cette dernière étape empêchera la propagation des défauts induits par contraintes à partir de la couche de masquage lorsque l'on procèdera à l'étape de dépôt d'un masque contre l'oxydation, typiquement en nitrure de silicium, directement sur la surface dudit substrat.

Dans un mode particulier de réalisation de l'invention, l'étape (D) de ce procédé est suivie par une étape (E) d'élimination de ladite couche superficielle endommagée dudit substrat semi-conducteur.

D'autres modes particuliers de réalisation de l'invention sont décrits dans les revendications 3 à 8. L'invention est exposée ci-après plus en détail à l'aide de dessins représentant seulement un mode de réalisation.

*Brève description des dessins*

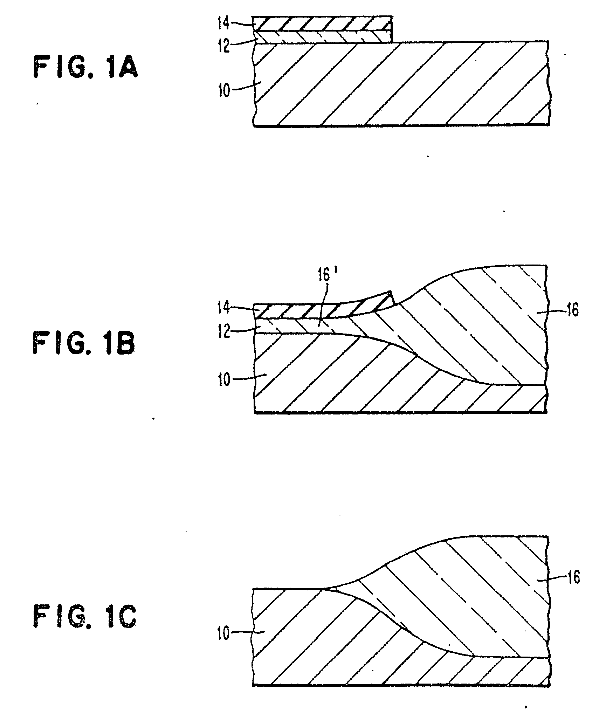

Les figures 1A, 1B et 1C représentent différentes étapes de la fabrication d'une région d'oxyde encastrée dans un substrat semi-conducteur typiquement de silicium en utilisant un masque pour l'oxydation composite: nitrure-dioxyde de silicium, tel qu'il est réalisé habituellement dans l'art antérieur.

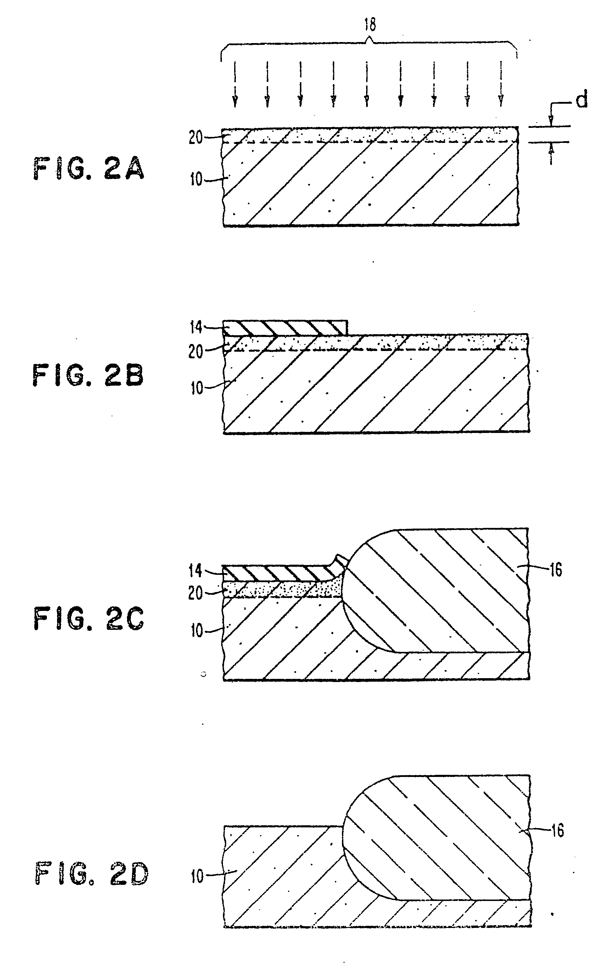

Les figures 2A, 2B, 2C et 2D, illustrent différentes étapes de la fabrication d'une région d'oxyde encastrée dans un substrat semi-conducteur typiquement de silicium en utilisant un masque pour l'oxydation en nitrure, placé directement sur le substrat, après que ce dernier ait subi les étapes d'implantation ionique et de recuit conformément aux principes de la présente invention.

*Description d'un mode de Réalisation*

Les figures 1A, 1B et 1C sont des vues en coupe qui représentent le phénomène de formation d'un bec d'oiseau. Sur la figure 1A, on représente un substrat de silicium 10 et un masque d'oxydation 14 en nitrure de silicium déposé sur la région désirée. Les masque de nitrure de silicium 14 est séparé du substrat 10 par une couche 12 de dioxyde de silicium, puisque, comme on l'a vu placer le masque de nitrure 14 directement sur le substrat 10 entraînerait des déformations par contraintes dans ce substrat enconduirait ainsi à des dispositifs faiblement performants.

Sur la figure 1B, l'oxyde encastré 16 est obtenu par croissance thermique dans la région désirée non masquée et une saillie 16' apparaît sous le masque 14. Après l'étape d'oxydation, le masque 14 est éliminé tel que représenté sur la figure 1C. A cause de cette saillie relativement large d'oxyde de silicium 16', le long de la configuration d'oxyde encastré, une portion qui ressemble à un bec d'oiseau demeure après l'élimination du masque au nitrure 14 et de la couche d'oxyde mince sous-jacente 12, par un procédé de décapage approprié. Cette portion en forme de bec d'oiseau produit un effet de masquage non désiré lors des procédés de diffusion ultérieurs et peut même déterminer la frontière latérale de la zone diffusée, auquel cas la jonction p-n formée entre la zone diffusée et le substrat peut présenter des bords courbés. Dans des étapes de fabrication ultérieures, lors de la fabrication de la zone diffusée il est même possible que la jonction p-n puisse être exposée à la surface du substrat.

Comme décrit dans le brevet US—A—3 900 350 sus-mentionné, on pourra utiliser une couche de silicium polycristallin au lieu et place de la couche de dioxyde de silicium. Cette couche de silicium polycristallin placée sur le substrat de silicium monocristallin réduit les contraintes dues au masque de nitrure et en même temps réduit à un minimum la saillie en forme de bec d'oiseau. Cependant cette technique met ainsi en oeuvre une couche intermédiaire relativement épaisse qui doit être enlevée soit directement, soit indirectement après conversion en oxyde, par une étape de décapage.

La figure 2A représente, en coupe, un substrat de silicium 10 qui a été soumis à un faisceau d'ions jusqu'à une profondeur contrôlée d. L'implantation ionique produit une couche très endommagée 20 pratiquement en silicium amorphe à la surface du substrat 10. Le substrat 10 est alors recuit et la couche fortement endommagée 20 génère un réseau de dislocation très dense, dont la microstructure dépend de l'énergie, de la dose et de la nature des ions utilisés pendant l'operation d'implantation.

Le réseau de dislocation dense obtenu après les étapes d'implantation et de recuit, protège le silicium monocristallin sous-jacent des défauts induits par contraintes et permet au masque d'oxydation au nitrure 14 d'être disposé directement sur le substrat 10 tel qu'illustré sur la figure 2B.

La surface du substrat 10 après les étapes d'implantation et de recuit est aussi protégée contre l'oxydation de sorte qu'on n'obtient pas de saillie en forme de bec d'oiseau. Ainsi, la figure 2C illustre la structure après l'étape d'oxydation, et la figure 2D illustre la structure après l'élimination du masque d'oxydation au nitrure et (si nécessaire) du réseau de dislocations dense 20, région dans laquelle ne s'est pas formé de bec d'oiseau.

Un exemple de fabrication d'un mode de réalisation de l'invention peut être décrit de la façon suivante:

Etape préalable: élaboration d'un substrat de silicium (10);

Etape (A): implantation d'ions Ar dans le substrat de silicium 10 avec une énergie d'implantation de 20KeV, une dose totale d'environ $10^{15}$at.cm$^{-2}$, pour constituer la couche 20 qui peut alors être recuite par les techniques classiques;

Etape (B): dépôt à faible température de $Si_3N_4$ jusqu'à atteindre une épaisseur de l'ordre de 30 nm à 100 nm (300 à 1000 Å) pour réaliser la couche 14; et délimitation dudit masque d'oxydation en $Si_3N_4$ par des procédés appropriés (par exemple photolithographiques) pour obtenir la configuration désirée;

Etape (C): oxydation jusqu'à l'obtention d'une épaisseur désirée: 650 nm (6500 Å) par exemple, par exposition à des atmosphères alternativement séche-humide-séche;

Etape (D): élimination du masque d'oxydation en $Si_3N_4$ par un procédé classique tel que le décapage par un mélange d'acide HF tamponné et d'acide phosphorique concentré;

Etape (E): élimination de la couche de silicium endommagée, si cela est nécesaire, soit par décapage de la couche de silicium (environ 50 nm (500 Å)) soit par oxydation de la région endommagée: (croissance de $SiO_2$ jusqu'à environ 100 nm (1000 Å), suivie de l'élimination par décapage, de l'oxyde ainsi formé.

Il est possible de réaliser l'étape (A) après l'étape (B) pourvu que l'énergie ionique soit suffisamment importante pour réaliser l'operation d'implantation à travers la couche de nitrure. Le choix des ions non dopants est déterminé principalement par le fait qu'ils ne doivent pas, dans la plupart des cas, réagir électriquement avec le silicium. Par exemple, Si, Ge, Ar, Ne et O sont des corps possibles.

L'implantation d'ions de silicium quand elle est utilisée pour améliorer la qualité du silicium est connue. La publication de S.M. Hu parue dans "IBM Technical Disclosure Bulletin", Vol. 19, No. 2, juillet 1976, intitulée "Hardening Silicon Wafers by Ion Implantation" décrit cette technique pour réduire les dislocations dans des tranches de silicium soumises à des contraintes thermiques.

L'énergie de l'implantation commande la profondeur de la région endommagée. La dose d'ions devra être proche de la dose critique pour qu'il se forme effectivement une couche amorphe continue dans le silicium, par exemple une dose comprise entre $5 \times 10^{14}$ et $10 \times 10^{14}$ ions par cm$^2$ (pour de l'argon dans du silicium) convient. En outre, on notera que l'étape (E) peut ne pas être nécessaire dans la fabrication des dispositifs bipolaires mais l'être dans la fabrication des transistors à effet de champ de type MOS.

*Application industrielle*

Ce qui a été décrit ci-dessus est donc un procédé amélioré de fabrication de dispositifs semi-conducteurs dans lequel le phénomène appelé "bec d'oiseau" est éliminé, en soumettant un substrat semi-conducteur à une implantation ionique de façon à générer un réseau de dislocation, la couche superficielle ainsi endommagée pouvant recevoir directement un masque de nitrure sans qu'une couche de dioxyde de silicium intermédiaire soit nécessaire. Ce procédé est donc d'un grand intérêt dans le domaine de la fabrication de dispositifs intégrés à semi-conducteurs à grande densité en particulier ceux isolés par des régions de matériau diélectrique encastrées.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de fabrication de dispositifs semi-conducteurs comportant des régions d'oxyde encastrées (16) réalisées à partir d'un masque d'oxydation (14) formé sur une surface d'un substrat semi-conducteur, qui comporte la séquence d'étapes suivante:

(A) implantation d'ions non dopants à travers ladite surface pour créer dans ledit substrat semi-conducteur (10) une couche superficielle endommagée (20) jusqu'à une profondeur contrôlée et recuit pour créer un réseau dense de dislocations,

(B) formation du masque d'oxydation (14) directement sur ladite surface du substrat semi-conducteur selon une configuration désirée,

(C) oxydation des régions du substrat exposées à travers les ouvertures dudit masque d'oxydation (14), et

(D) élimination dudit masque d'oxydation (14) après l'oxydation.

2. Procédé selon la revendication 1 caractérisé en ce que l'étape (D) est suivie par une étape:

(E) d'élimination de la couche superficielle endommagée (20) dudit substrat semi-conducteur (10).

3. Procédé selon la revendication 1 ou 2 caractérisé en ce que dans la séquence les étapes (A) et (B) sont inversées et que dans ce cas l'énergie ionique doit être suffisante pour réaliser l'implantation à travers le masque d'oxydation (14).

4. Procédé selon la revendication 1, 2 ou 3, caractérisé en ce que ledit masque d'oxydation (14) est constitué par du $Si_3N_4$.

5. Procédé selon l'une quelconque des revendications ci-dessus caractérisé en ce que le substrat semi-conducteur (10) est un substrat silicium monocristallin.

6. Procédé selon la revendication 5 caractérisé en ce que lesdits ions non dopants sont choisis dans le groupe comprenant Ar, Ge, Ne, O et Si.

7. Procédé selon la revendication 6 caractérisé en ce que lesdits ions non dopants sont des ions Ar, la dose implantée étant voisine de la dose critique pour transformer la couche superficielle du substrat silicium en du silicium amorphe.

8. Procédé selon la revendication 7 caractérisé en ce que ladite dose est comprise entre $5 \times 10^{14}$ et $10 \times 10^{14}$ ions.cm².

**Claims**

1. A method of manufacturing semiconductor devices comprising recessed oxide regions (16) obtained by means of an oxidation mask (14) formed on the surface of a semiconductor s. ·strate, which includes the following steps:

(A) implanting non-doping ions across said surface to obtain a superficial layer (20) damaged to a controlled depth in said semiconductor substrate (10) and annealing to generate a dense dislocation network,

(B) forming an oxide mask (14) directly on said surface of the semiconductor substrate according to a predetermined configuration,

(C) oxidizing the substrate regions exposed through the openings of said oxidation mask (14), and

(D) eliminating said oxidation mask (14) after the oxidation process.

2. Method according to claim 1, characterized in that step (D) is followed by step:

(E) eliminating the superficial damaged layer (20) of said semiconductor substrate (1'0).

3. Method according to claim 1 or 2, characterized in that in the step sequence, steps (A) and (B) are reversed, in which case the ion energy must be sufficient to carry out the implantation through the oxidation mask (14).

4. Method according to claim 1, 2 or 3, characterized in that said oxidation mask (14) is composed of $Si_3N_4$.

5. Method according to any one of the above claims, characterized in that the semiconductor substrate (10) is a monocrystalline silicon substrate.

6. Method according to claim 5, characterized in that said non-doping ions are chosen in the group including Ar, Ge, Ne, O, and Si.

7. Method according to claim 6, characterized in that said non-doping ions are Ar ions, the implanted dose being close to the critical dose in order to transform the superficial layer of the silicon substrate into amorphous silicon.

8. Method according to claim 7, characterized in that said dose is comprised between $5 \times 10^{14}$ and $10 \times 10^{14}$ ions.cm².

**Patentansprüche**

1. Verfahren zur Herstellung von Halbleitervorrichtungen mit eingelegten Oxidbereichen (16), die mit Hilfe einer auf einer Oberfläche eines Halbleitersubstrates gebildeten Oxidationsmaske (14) erzeugt werden, das folgende Verfahrensschritte einschließt:

(A) Implantieren von nicht-dotierenden Ionen durch diese Oberfläche hindurch zur Bildung einer bis zu einer definierten Tiefe beschädigten Oberflächenschicht (20) in diesem Halbleitersubstrat (10), und Tempern zur Bildung eines dichten Netzes von Versetzungen,

(B) Bildung einer Oxidationsmaske (14) direkt auf dieser Oberfläche des Halbleiter- substrats gemäß einem gewünschten Muster,

(C) Oxidieren der in den Öffnungen dieser Oxidationsmaske (14) freiliegenden Substratbereiche, und

(D) Beseitigung dieser Oxidationsmaske (14) nach der Oxidation.

2. Verfahren nach Anspruch 1, dadurch gekennzeichnet, daß dem Verfahrensschritt (D) ein weiterer Verfahrensschritt folgt:

(E) Beseitigung der beschädigten Oberflächenschicht (20) des Halbleiterstubstrats (10).

3. Verfahren nach Anspruch 1 oder 2, dadurch gekennzeichnet, daß die Aufeinander-folge der Verfahrensschritte (A) und (B) umgekehrt wird, und daß in diesem Falle die Ionenenergie zum Implantieren durch die Oxidationsmaske (14) hindurch hoch genug sein muß.

4. Verfahren nach Anspruch 1, 2 oder 3, dadurch gekennzeichnet, daß die Oxidationsmaske (14) aus $Si_3N_4$ besteht.

5. Verfahren nach einem der obigen Ansprüche, dadurch gekennzeichnet, daß das Halbleitersubstrat (10) ein einkristallines Siliziumsubstrat ist.

6. Verfahren nach Anspruch 5, dadurch gekennzeichnet, daß diese nicht-dotierenden Ionen aus der Gruppe Ar, Ge, Ne, O und Si ausgewählt werden.

7. Verfahren nach Anspruch 6, dadurch gekennzeichnet, daß diese nicht-dotierenden Ionen Ar-Ionen sind, wobei die implantierte Dosis der kritischen Dosis nahekommt, bei der sich die Oberflächenschicht des Siliziumsubstrats in amorphes Silizium verwandelt.

8. Verfahren nach Anspruch 7, dadurch gekennzeichnet, daß diese Dosis zwischen $5 \times 10^{14}$ und $10 \times 10^{14}$ Ionen/cm$^{-2}$ liegt.

FIG. 1A

14
12
10

FIG. 1B

16'
14
12
10
16

FIG. 1C

16
10

1

**FIG. 2A**

**FIG. 2B**

**FIG. 2C**

**FIG. 2D**